# EUROPEAN PATENT SPECIFICATION

(11) **EP 1 269 479 B1**
(45) Date of publication and mention of the grant of the patent: **29.03.2006**
(21) Application number: 01909081.0
(22) Date of filing: 08.02.2001
(51) Int. Cl.: G11C 19/18, H04N 3/15, H01L 27/105

(54) **BI-DIRECTIONAL CAPABLE BUCKET BRIGADE CIRCUIT**
BIDIREKTIONALE EIMERKETTENSCHALTUNG
CIRCUIT EN CHAPELET BIDIRECTIONNEL

(43) Date of publication of application: 02.01.2003
(73) Proprietor: RAYTHEON COMPANY, Lexington, Massachusetts 02421 (US)
(72) Inventor: CHEN, Leonard, P., Santa Barbara, CA 93105 (US); CHANG, Howard, T., Santa Barbara, CA 93103 (US); HERRIN, Eileen, M., Goleta, CA 93117 (US); HEWITT, Mary, J., Santa Barbara, CA 93111 (US); VAMPOLA, John, L., Santa Barbara, CA 93111 (US)
(74) Representative: Jackson, Richard Eric
(86) International application number: PCT/US2001/004330
(87) International publication number: WO 2002/063633

(56) References cited:
- GB-A- 2 343 577
- US-A- 3 683 193
- US-A- 5 315 114
- MARTIN R J ET AL: "PROCEEDINGS OF THE SPIE, SPIE, BELLINGHAM, VA, US" PROCEEDINGS OF THE SPIE, SPIE, BELLINGHAM, VA, US, vol. 930, 6 April 1988 (1988-04-06), pages 26-43, XP000601288

## Description

This invention was made with Government support under contract awarded by the Government. The Government has certain rights in this invention.

### BACKGROUND OF THE INVENTION

### Field of the Invention:

The present invention relates to circuits useful in processing the output of image sensing arrays. More specifically, the present invention relates to Time Delay Integration ("TDI") circuits useful in processing the output of image sensing arrays.

### Description of the Related Art:

The Time-Delay-Integration ("TDI") architecture is typically found in high speed digital image sensing devices such as Charge Coupled Device ("CCD") image sensors to achieve satisfactory sensitivity. It has utility with many various types of image sensing arrays variously sensitive to, for example, the infrared, visible light, and X-ray wavelengths. In an image sensing device with a TDI architecture, an image is optically scanned so that each part of the image is sensed with different parts, typically lines, of the image sensing array in a synchronized, delayed manner. The plural outputs over time of the image sensing array for each part of the image are summed, thereby improving the sensitivity and spatial resolution of the image sensing device. One measure of performance of image sensing devices is the Modulation Transfer Function ("MTF"), which is defined as the ratio of the modulation of the output signal to the modulation of the input signal, versus spatial frequency.

Typically, the TDI circuits are implemented in a type of silicon-based integrated circuit known as a Read-Out Integrated Circuit ("ROIC"), which is combined with the sensing array to form a Sensor Chip Assembly ("SCA"). SCAs are used in a variety of digital imaging systems, including, for example, night vision cameras, surveillance cameras, remote imaging cameras, and manufacturing line inspection cameras, and are suitable even for standard army dewar assembly ("SADA") type applications and three color activities. Multiple color band activities are scanning systems which incorporate more than one spectral band, or color, on a SCA. Each of the colors is defined by a bank of sensing elements on which a single spectral color is incident. SCAs are particularly useful when the sensing array is made of a non-silicon semiconductor material, which is typical because non-silicon semiconductor materials are inherently sensitive to various useful portions of the electromagnetic spectrum. Image information in the form of electrical charge is produced in the imaging array. The charge is collected and processed by the typically silicon-based ROIC. SCAs are manufactured using a variety of well known techniques, ranging from fabricating the sensing array separately from the ROIC and mounting the sensing array and ROIC on a common substrate or a common printed circuit board, to mounting the sensing array substrate on the ROIC substrate and then fabricating the sensing array.

TDI has been performed with both voltage transfer devices and charge transfer devices. Charge coupled devices ("CCDs") transfer charge by modulating the surface potential in a semiconductor. For example, time delay integration may be performed in a SCA TDI architecture using a CCD array in a "side rider" configuration. Bucket brigade devices ("BBDs") move charge by utilizing the threshold barrier formed by MOSFETs. Time delay integration can be implemented using standard bucket brigade ("BBD") circuits.

CCDs and BBDs preferably should have a bi-directional capability for certain types of applications such as, rotating mirror scanning arrays. The conventional approach to achieve bi-directionality has been to use two bucket brigade structures, one for each direction, or two CCDs, or two CCDs with switched or reconfigurable inputs, which read the unit cell outputs. The use of reconfigurable inputs requires multiplexer circuitry to place the unit cell outputs onto a single column bus, a programmable clock to synchronize the column bus output to the CCD bucket inputs, and demultiplexer circuitry to place the synchronized column bus signal into the CCD buckets. The increased amount of additional circuitry used to achieve bi-directionality in these conventional approaches is undesirable.

US 5,315,114 discloses a uni-directional device in which detector samples are accumulated over multiple dwell times, with the signals time-delayed and subsequently integrated with correlated samples. The detector array signals are processed as follows: detector samples are taken and stored on the switch capacitor, at the proper time the stored data are loaded onto the proper port of a shift-and-store function implemented in a BBD, samples are summed with the sample remaining from the previous dwell time, and the summed data are shifted to the next stage in the BBD or to the output. The output signal represents the summation of a number of detector samples equal to the number of detector columns coupled to the BBD shift-and-store function.

Hence, a need exists in the art for a TDI circuit that is useful for bi-directional processing of the output of image sensing arrays without using switched or reconfigurable inputs, and that has reduced ROIC circuitry relative to the ROIC circuitry required in the side rider CCD implementation.

### SUMMARY OF THE INVENTION

The need in the art is addressed by the present invention, which in one embodiment is a time delay integration circuit comprising a plurality of serially coupled circuit groups, each comprising at least; a first charge transfer path segment having a first gate and a second gate in series between a first end and a second end thereof; a second charge transfer path segment having a first gate and a second gate in series between a first end and a second end thereof the first end of the second charge transfer path being coupled to the second end of the first charge transfer path; a first capacitor having a first terminal coupled to the first end of the first charge transfer path segment and a second terminal; and a second capacitor having a first terminal coupled to the first end of the second charge transfer path segment and a second terminal; a plurality of imaging sensor unit cell inputs respectively controllably coupled to the first terminals of the second capacitors; a screen voltage node controllably coupled in a first charge transfer direction to the first gates and in a second charge transfer direction to the second gates; a first phase clock node coupled to the second terminals of the first capacitors and controllably coupled in the first charge transfer direction to the second gates of the second charge transfer path segments and in the second charge transfer direction to the first gates of the first charge transfer path segments; and a second phase clock node coupled to the second terminals of the second capacitors and controllably coupled in the first charge transfer direction to the second gates of the first charge transfer path segments and in the second charge transfer direction to the first gates of the second charge transfer path segments.

Another embodiment of the invention is a method of time delay integration of image sensor charges, comprising: storing a charge on a first capacitor; acquiring a first image sensor charge; transferring the first image sensor charge to a second capacitor; transferring the charge on the first capacitor from the first capacitor to the second capacitor in a first direction along a first charge transfer path to add the charge on the first capacitor to the first image sensor charge, thereby obtaining a first accumulated charge; transferring the first accumulated charge from the second capacitor to a third capacitor in the first direction along a second charge transfer path to store the first accumulated charge; acquiring a second image sensor charge, the second image sensor charge being a time delayed version of the first image sensor charge; transferring the second image sensor charge to a fourth capacitor; transferring the first accumulated charge from the third capacitor to the fourth capacitor in the first direction along a third charge transfer path to add the first accumulated charge to the second image sensor charge, thereby obtaining a second accumulated charge; transferring the second accumulated charge from the fourth capacitor to a fifth capacitor in the first direction along a fourth charge transfer path to store the second accumulated charge; storing a charge on the fifth capacitor, acquiring a third image sensor charge; transferring the third image sensor charge to the fourth capacitor; transferring the charge on the fifth capacitor from the fifth capacitor to the fourth capacitor in a second direction along the fourth charge transfer path to add the charge on the fifth capacitor to the third image sensor charge, thereby obtaining a third accumulated charge; transferring the third accumulated charge from the fourth capacitor to a third capacitor in the second direction along the third charge transfer path to store the third accumulated charge; acquiring a fourth image sensor charge, the fourth image sensor charge being a time delayed version of the third image sensor charge; transferring the fourth image sensor charge to the second capacitor; transferring the third accumulated charge from the third capacitor to the second capacitor in the second direction along the second charge transfer path to add the third accumulated charge to the fourth image sensor charge, thereby obtaining a fourth accumulated charge; and transferring the fourth accumulated charge from the second capacitor to the first capacitor in the second direction along the first charge transfer path to store the fourth accumulated charge; wherein
said first, second, third and fourth charge transfer paths have first gates and second gates respectively connected in series between first and second ends of said first, second, third and fourth charge transfer paths, said first and second gates respectively functioning alternatively as screen gates or as transfer gates according to a clocking phase, thus allowing charge transfer in said first direction or said second direction.

### BRIEF DESCRIPTION OF THE DRAWINGS

Figure 1 is a four-phase CCD circuit diagram.
Figure 2 is a conventional BBD circuit diagram.
Figure 3 is a circuit diagram of a bi-directional bucket brigade circuit for a two sample per dwell TDI, in accordance with the present invention.
Figures 4-6 are tables of charge transfers useful in understanding the operation of the circuit of Figure 3.
Figures 7-8 are waveform diagrams useful in understanding the operation of the circuit of Figure 3.

### DESCRIPTION OF THE INVENTION

Illustrative embodiments and exemplary applications will now be described with reference to the accompanying drawings to disclose the advantageous teachings of the present invention.

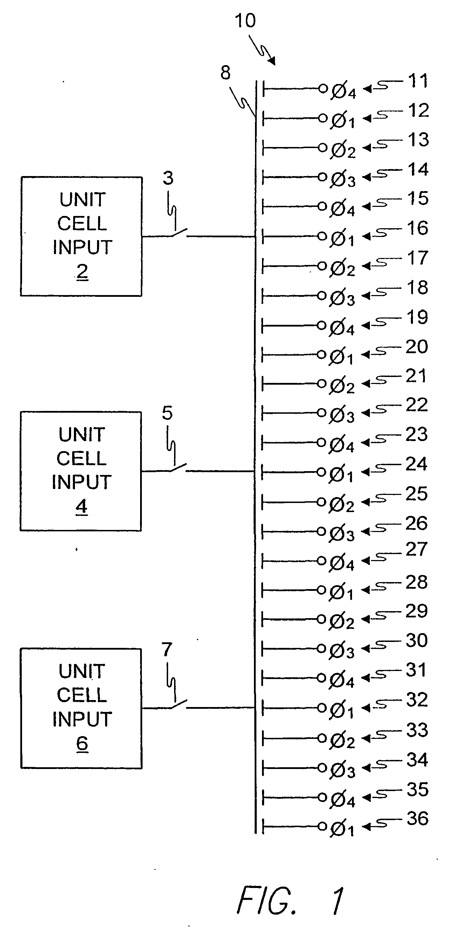

Figure 1 shows an illustrative segment 10 of a CCD in a "side rider" configuration for a 2 sample per dwell implementation; see, *e.g.,* "High Performance InSb Scanning Sensor Chip with 26 In TDI," Proceedings of the IRIS, August, 1992. The side rider CCD implementation operates by injecting charge into every other ∅₁ bucket of the CCD circuit from the multiplexed unit cell outputs. Segment 10 includes gates 11-36, which are alternately clocked by clock phases ∅₁ ∅₂, ∅₃, and ∅₄. One complete clocking cycle of ∅₁ ∅₂, ∅₃, and ∅₄ constitutes an addition, transfer, and storage cycle. One typical scheme to operate such a CCD implementation is described as follows. At the beginning of an addition, transfer, and storage cycle the wells under the gates controlled by ∅₁ are empty and the wells under the gates controlled by ∅₃ have charge stored from the previous cycle. The barriers under the gates controlled by ∅₂ and ∅₄ are at a high potential in order to isolate the ∅₁ and ∅₃ gates. Unit cell inputs 2, 4, and 6 inject their respective signals into the empty CCD wells under the gates controlled by clock phase ∅₁, namely gates 16, 24, and 32. This is done by any of various techniques, from charge sharing to fill/spill injectors. ∅₄ is then appropriately clocked such that the barrier under its respective gates is lowered, and the ∅₃ gates are clocked such that the charges that is stored under these gates are transferred and added to the charges that are under the ∅₁ gates. The barrier under the gate controlled by ∅₄ is raised, and the potential under the now empty ∅₃ wells is lowered. The barrier under ∅₂ is now lowered to allow the charges under the ∅₁ gates to be transferred to the ∅₃ gates, and ∅₁ is clocked to complete the transfer. The addition, transfer, and storage cycle is complete once the barrier under the ∅₂ gates is raised and the potential under the ∅₁ gates is lowered. The summed charges are now stored in the wells under the gates controlled by ∅₃, and the wells under the ∅₁ gates are once again empty.

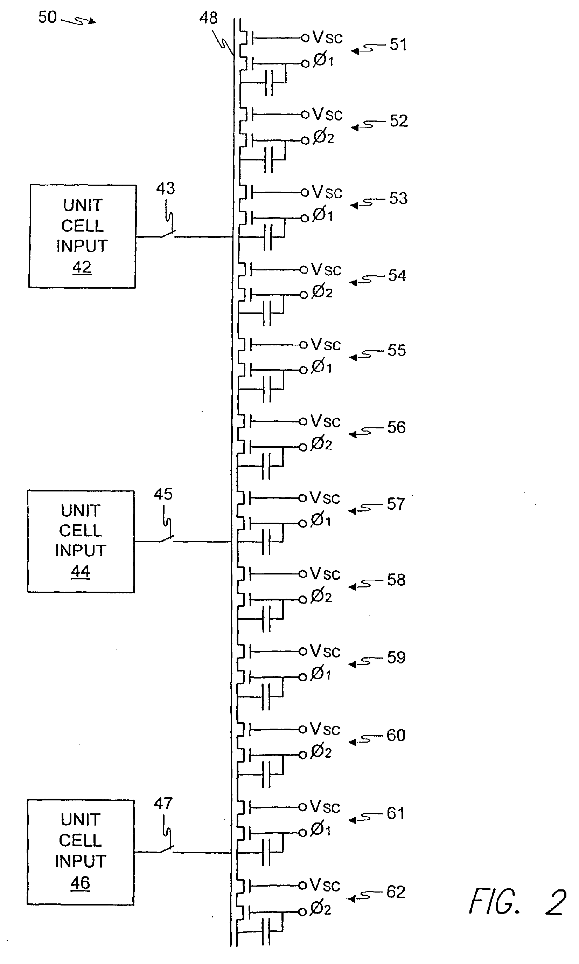

Figure 2 shows an illustrative segment 50 of a bucket brigade device, which has a number of MOS transistor pairs combined with respective capacitors. The MOS transistor pairs have respective screen gates to which V_{SC} is applied, and transfer gates alternately clocked by clock phase ∅₁ and clock phase ∅₂. The capacitors also are clocked alternately by clock phase ∅₁ and clock phase ∅₂. One complete clocking cycle of ∅₁ and ∅₂ constitutes an addition, transfer, and storage cycle. One typical scheme to operate such a BBD implementation is described as follows. At the beginning of an addition, transfer, and storage cycle the capacitor node connected to the drain of the transistor controlled by ∅₁ is at its reset potential. The transistors controlled by ∅₂ are OFF to isolate the ∅₁ and ∅₂ capacitors. Unit cell inputs 42, 44, and 46 inject their respective signals into the drain connected side of the capacitors gates controlled by clock phase ∅₁, namely the capacitors of elements 53, 57, and 61. This is done by any of various techniques, from charge sharing to Thompsett type injection. ∅₁ is then appropriately clocked in order to transfer and add the stored charge in the ∅₂ controlled capacitors. Charge stored in the capacitors of elements 52, 56, and 60 are added to the capacitors in 53, 57, and 61, respectively, and the charge stored in the capacitors of 54 and 59 are just transferred to capacitors in 55 and 60, respectively. ∅₁ is clocked OFF. ∅₂ is then appropriately clocked in order to transfer the accumulated charge in the ∅₁ controlled capacitors to the ∅₂ controlled capacitors. The charge in the capacitors of 51, 53, 55, 57, 59, and 61 are transferred and stored on the capacitors in 52, 54, 56, 58, 60, and 62, respectively. During this process, the capacitors of 51, 53, 55, 57, 59, and 61 are also automatically reset. ∅₁ is clocked OFF. The addition, transfer, and storage cycle is complete and the summed charges are now stored in the capacitors controlled by ∅₂. The screen gates serve to improve the charge transfer efficiency. The BBD described above is suitable for a 2-sample per dwell implementation.

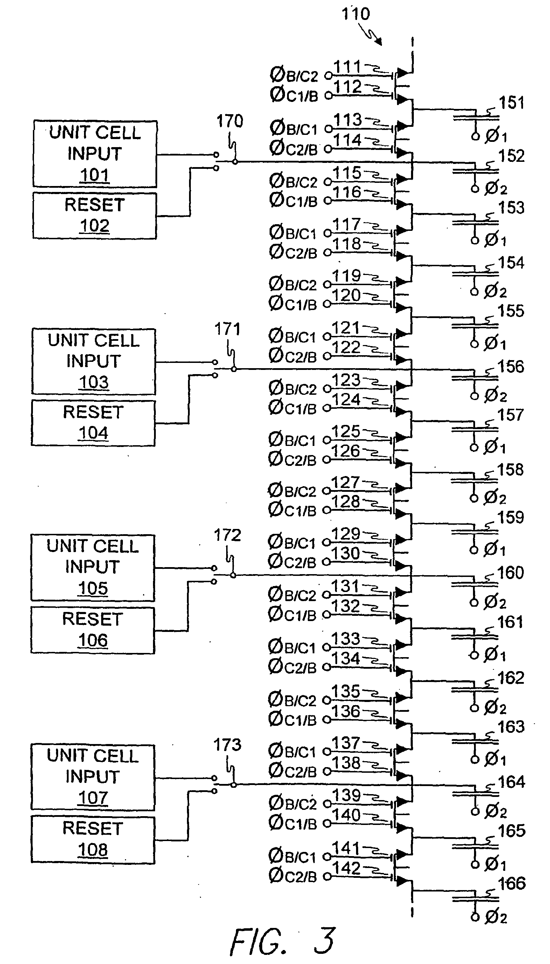

Figure 3 shows a representative segment of a bi-directional BBD circuit 110, which performs an SCA TDI with reduced ROIC circuitry. The reduction in the ROIC circuitry is achievable because the required area for the charge transfer device is reducible by approximately 50 percent relative to CCDs with switched inputs. CCDs with switched inputs require injection circuits that are clocked in a particular order depending on scan direction. The bi-directional BBD does not require this circuitry, where charge is injected directly by the unit cell, and allows reductions in the overall ROIC area of about 20 percent or more. Moreover, clock and bias generation both on the SCA and off of the SCA is reducible, and compatibility with standard LSI processing is preserved inasmuch as the specialized processing for the two level polysilicon structures used in CCD implementation is not required. Performance is similar to CCD implementations.

Four representative unit cell inputs 101, 103, 105 and 107 are shown in Figure 3, along with respective switches 170, 171, 172 and 173, which preferably are transistor switches. The segment 110 has numerous pairs of MOSFET transistors connected in series and numerous storage capacitors having one of their terminals respectively connected between each of the MOSFET pairs and the other of their terminals alternately connected to clock phases ∅₁ and ∅₂. The gates of the two MOSFETs in each pair are separated from the clock phases ∅₁ and ∅₂ and function respectively as screen gate and transfer clock for one direction of charge flow, and as transfer clock and screen gate for the other direction of charge flow. Transfer direction is changed by switching which MOSFET in a pair becomes clocked as a transfer gate and which becomes a screen gate. Advantageously, the presence of a screen gate in the charge transfer path increases the transfer efficiency of the bucket brigade device in both directions, which is desirable for operating scanning IR SCAs where TDI is performed on-chip.

The signal convention used in Figure 3 for the gates of the various MOSFETS of the bi-directional BBD circuit 110 is as follows. The first symbol in the signal ∅ subscript indicates the function of the gate in the DOWN direction, the second symbol in the signal ∅ subscript indicates the function of the gate in the UP direction. The symbol "B" represents a screen voltage, the symbol "C1." represents capacitor clock phase ∅_{1,} and symbol "C2" represents capacitor clock phase ∅₂.

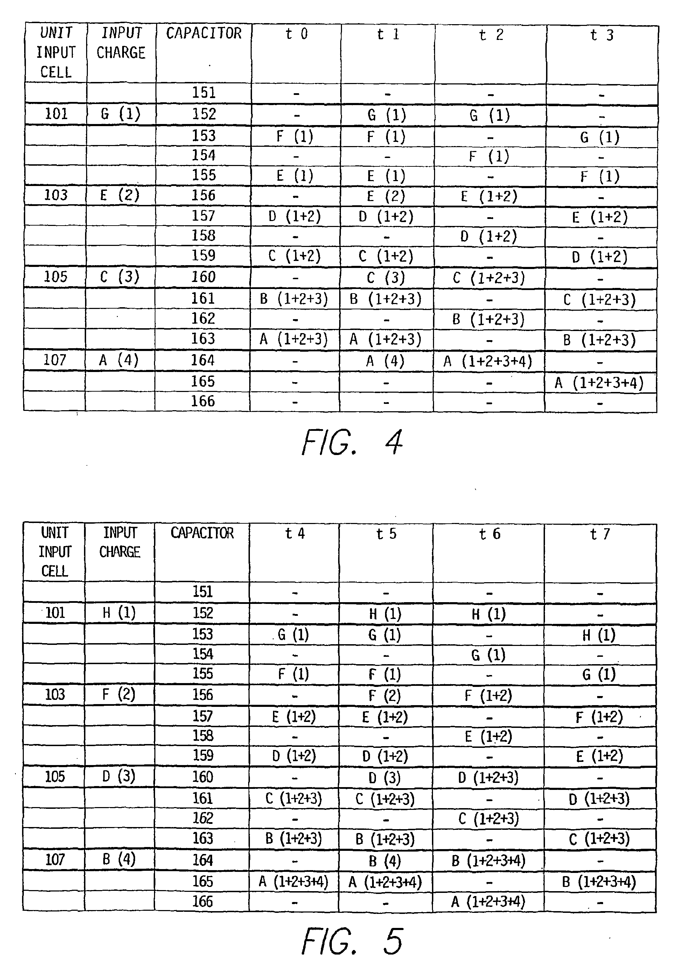

In the following description of the operation of the bi-directional BBD circuit 110, charge at a node is represented by a letter indicating the image sample that the detector starts at, and the parenthetical numerical values indicate the TDI number. Figures 4 and 5 show transfers in the DOWN direction, with MOS transistors 111, 113, 115, 117, 119, 121, 123, 125, 127, 129, 131, 133, 135, 137, 139 and 141 having their gates at screen potential. The bi-directional BBD circuit 110 is suitable for a two sample per dwell SCA, and Figure 4 pertains to the first sample of charges A(4), C(3), E(2) and G(1) while Figure 5 pertains to the second sample of charges B(4), D(3), F(2) and H(1). If desired, the bi-directional BBD circuit 110 may be made suitable for a single sample per dwell SCA by reducing the number of the MOS transistor pairs between adjacent unit cell inputs to two, or may be made suitable for more than two samples per dwell by adding additional MOS transistor pairs between adjacent unit cell inputs.

Figure 4 shows illustrative initial conditions on the capacitors 151-166 at time to when the capacitors 152, 156, 160 and 164 are connected to reset circuits 102, 104, 106 and 108 through switches 170, 171, 172 and 173 respectively. At time t₁, input charges G(1), E(2), C(3) and A(4) from the first sample set are available on unit cell inputs 101, 103, 105 and 107 and are transferred to capacitors 152, 156, 160 and 164 through switches 170, 171, 172 and 173 respectively. At time t₂, MOS transistors 114, 118, 122, 126, 130, 134, 138 and 142 are clocked ON by clock phase ∅₂ so that charge is transferred from capacitor 151 and added to the input charge stored in capacitor 152, transferred from capacitor 153 to capacitor 154, transferred from capacitor 155 and added to the input charge stored in capacitor 156, transferred from capacitor 157 to capacitor 158, transferred from capacitor 159 and added to the input charge stored in capacitor 160, transferred from capacitor 161 to capacitor 162, transferred from capacitor 163 and added to the input charge stored in capacitor 164, and transferred from capacitor 165 to capacitor 166. MOS transistors 112, 116, 120, 124, 128, 132, 136 and 140 are OFF by clock phase ∅₁ so that the transferred and accumulated charges are isolated: At time t₃, MOS transistors 116, 120, 124, 128, 132, 136 and 140 are clocked ON by clock phase ∅₁ so that charge is transferred from capacitor 152 to capacitor 153, from capacitor 154 to capacitor 155, from 156 to capacitor 157, from capacitor 158 to capacitor 159, from capacitor 160 to capacitor 161, from capacitor 162 to capacitor 163, and from capacitor 164 to capacitor 165. MOS transistors 114, 118, 122, 126, 130, 134, 138 and 142 are OFF by clock phase ∅₂ so that the transferred and accumulated charges are isolated.

Figure 5 shows the initial conditions on the capacitors 151-166 at time t₄ when the capacitors 152, 156, 160 and 164 are connected to reset circuits 102, 104, 106 and 108 through switches 170, 171, 172 and 173 respectively. At time t₅, input charges H(1), F(2), D(3) and B(4) from the second sample set are available on unit cell inputs 101, 103, 105 and 107 and are transferred to capacitors 152, 156, 160 and 164 through switches 170, 171, 172 and 173 respectively. At time t₆, MOS transistors 114, 118, 122, 126, 130, 134, 138 and 142 are clocked ON by clock phase ∅₂ so that charge is transferred from capacitor 151 and added to the input charge stored in capacitor 152, transferred from capacitor 153 to capacitor 154, transferred from capacitor 155 and added to the input charge stored in capacitor 156, transferred from capacitor 157 to capacitor 158, transferred from capacitor 159 and added to the input charge stored in capacitor 160, transferred from capacitor 161 to capacitor 162, transferred from capacitor 163 and added to the input charge stored in capacitor 164, and transferred from capacitor 165 to capacitor 166. MOS transistors 112, 116, 120, 124, 128, 132, 136 and 140 are OFF by clock phase ∅₁ so that the transferred and accumulated charges are isolated. At time t₇, MOS transistors 116, 120, 124, 128, 132, 136 and 140 are clocked ON by clock phase ∅₁ so that charge is transferred from capacitor 152 to capacitor 153, from capacitor 154 to capacitor 155, from 156 to capacitor 157, from capacitor 158 to capacitor 159, from capacitor 160 to capacitor 161, from capacitor 162 to capacitor 163, and from capacitor 164 to capacitor 165. MOS transistors 114, 118, 122, 126, 130, 134, 138 and 142 are OFF by clock phase ⌀₂ so that the transferred and accumulated charges are isolated.

In the following description of the operation of the bi-directional BBD circuit 110, transfer is changed to the UP direction. This is achieved by placing the gates of MOS transistors 112, 114, 116,118, 120, 122, 124, 126, 128, 130, 132, 134,136,138, 140 and 142 at screen potential.

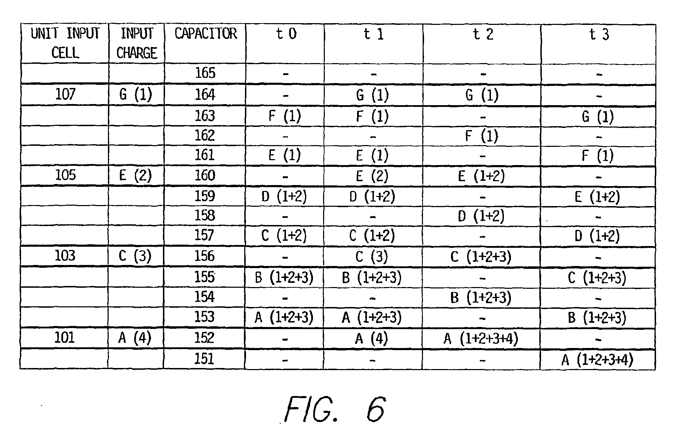

Figure 6 shows the initial conditions on the capacitors 151-166 at time to when the capacitors 152,156,160 and 164 are connected to reset circuits 102, 104, 106 and 108 through switches 170, 171, 172 and 173 respectively. At time t₁, input charges G(1), E(2), C(3) and A(4) from the first sample set are available on unit cell inputs 107, 105, 103 and 101 and are transferred to capacitors 164, 160, 156 and 152 through switches 173, 172, 171 and 170 respectively. At time t₂, MOS transistors 139, 135, 131, 127, 123, 119, 115 and 111 are clocked ON by clock phase ∅₂ so that charge is transferred from capacitor 165 and added to the input charge stored in capacitor 164, transferred from capacitor 163 to capacitor 162, transferred from capacitor 161 and added to the input charge stored in capacitor 160, transferred from capacitor 159 to capacitor 158, transferred from capacitor 157 and added to the input charge stored in capacitor 156, transferred from capacitor 155 to capacitor 154, transferred from capacitor 153 and added to the input charge stored in capacitor 152. MOS transistors 141, 137, 133, 129, 125, 121, 117 and 113 are OFF by clock phase ∅₁ so that the transferred and accumulated charges are isolated. At time t₃, MOS transistors 141, 137, 133, 129, 125, 121, 117 and 113 are clocked ON by clock phase ∅₁ so that charge is transferred from capacitor 166 to capacitor 165, from capacitor 164 to capacitor 163, from capacitor 162 to capacitor 161, from capacitor 160 to capacitor 159, from capacitor 158 to capacitor 157, from capacitor 156 to capacitor 155, from capacitor 154 to capacitor 153, and from capacitor 152 to capacitor 151. MOS transistors 139, 135, 131, 127, 123, 119, 115 and 111 are OFF by clock phase ∅₂ so that the transferred and accumulated charges are isolated.

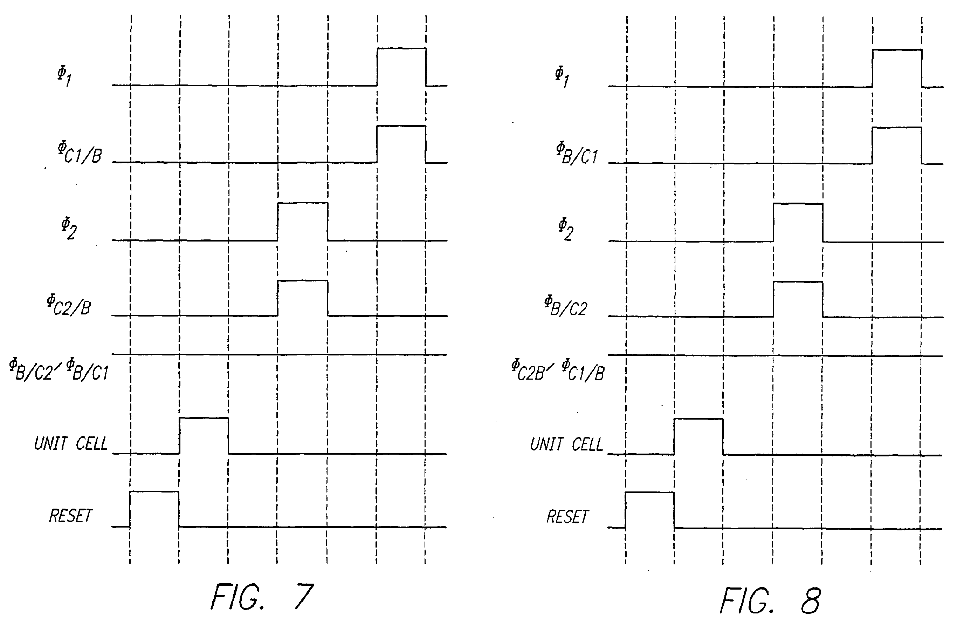

Figures 7 and 8 have been added to illustrate the various control and clock phase signals. Figure 7 shows the timing of the clock signals for scanning in the DOWN direction. Figure 8 shows the timing for scanning in the UP direction.

The bi-directional techniques used in the BBD circuit 110 may be used with multiplexed BBD circuits such as described in commonly assigned United States Patent No. 6,825,877 (Application of Hewitt et al. entitled "Multiplex Bucket Brigade Circuit,"), filed on 7^{th} January 2000.

## Claims

1. A time delay integration circuit (110) comprising:
a plurality of serially coupled circuit groups, each comprising at least:
a first charge transfer path segment having a first gate (113, 121, 129, 137) and a second gate (114, 122, 130, 138) in series between a first end and a second end thereof;
a second charge transfer path segment having a first gate (115, 123, 131, 139) and a second gate (116, 124, 132, 140) in series between a first end and a second end thereof, the first end of the second charge transfer path being coupled to the second end of the first charge transfer path;
a first capacitor (151, 155, 159, 163) having a first terminal coupled to the first end of the first charge transfer path segment and a second terminal; and
a second capacitor (152, 156, 160, 164) having a first terminal coupled to the first end of the second charge transfer path segment and a second terminal;
a plurality of imaging sensor unit cell inputs (101, 103, 105, 107) respectively controllably coupled to the first terminals of the second capacitors;
a screen voltage node (∅_{B}) controllably coupled in a first charge transfer direction to the first gates and in a second charge transfer direction to the second gates;
a first phase clock node (∅₁, ∅_{C1}) couple to the second terminals of the first capacitors and controllably coupled in the first charge transfer direction to the second gates of the second charge transfer path segments and in the second charge transfer direction to the first gates of the first charge transfer path segments; and
a second phase clock node (∅₂, ∅_{C2}) coupled to the second terminals of the second capacitors and controllably coupled in the first charge transfer direction to the second gates of the first charge transfer path segments and in the second charge transfer direction to the first gates of the second charge transfer path segments.

2. A time delay integration circuit as in claim 1 further comprising a plurality of reset inputs (102, 104, 106, 108) respectively controllably coupled to the first tenninals of the second capacitors.

3. A time delay integration circuit as in claim 1 or 2 further comprising a plurality of switch circuits (170, 171, 172, 173) having pole terminals respectively coupled to the second capacitors, first switched terminals respectively coupled to the imaging sensor unit cell inputs, and second switched terminals respectively coupled to the reset inputs.

4. A time delay integration circuit as in claim 3 wherein the switch circuits are MOSFET transistor switch circuits.

5. A time delay integration circuit as in claim 1, 2, 3 or 4 wherein each of the serially coupled circuit groups further comprises:
a third charge transfer path segment having a first gate (117, 125, 133, 141) and a second gate (118, 126, 134, 142) in series between a first end and a second end thereof;
a fourth charge transfer path segment having a first gate (119, 127, 135, 111) and a second gate (120, 128, 136, 112) in series between a first end and a second end thereof, the first end of the second charge transfer path being coupled to the second end of the first charge transfer path;
a third capacitor (153, 157, 161, 165) having a first terminal coupled to the first end of the third charge transfer path segment and a second terminal; and
a fourth capacitor (154, 158, 162, 166) having a first terminal coupled to the first end of the fourth charge transfer path segment and a second terminal;
wherein the screen voltage node (∅_{B}) further is controllably coupled in the first charge transfer direction to the first of the third and fourth charge transfer paths and in a second charge transfer direction to the second gates of the third and fourth charge transfer paths;
wherein the first phase clock node (∅₁, ∅_{C1}) is further couple to the second terminals of the third capacitors and controllably coupled in the first charge transfer direction to the second gates of the fourth charge transfer path segments and in the second charge transfer direction to the first gates of the third charge transfer path segments; and
wherein the second phase clock node (∅₂, ∅_{C2}) is further coupled to the second terminals of the fourth capacitors and controllably coupled in the firs to charge transfer direction to the second gates of the third charge transfer path segments and in the second charge transfer direction to the first gates of the fourth charge transfer path segments.

6. A time delay integration circuit as in claim 1, 2, 3, 4 or 5 further comprising a plurality of serially coupled MOSFET transistors (111, 112, 113, 114, 115, 116, 117, 118, 119, 120, 121, 122, 123, 124, 125, 126, 127, 128, 129, 130, 131, 132, 133, 134, 135, 136, 137, 138, 139, 140, 141, 142), the first and second gates being gates of the MOSFET transistors.

7. A method of time delay integration of image sensor charges, comprising:
storing a charge (E(1)) on a first capacitor (155);
acquiring a first image sensor charge (E(2));
transferring (t1) the first image sensor charge to a second capacitor (156);
transferring (t2) the charge on the first capacitor from the first capacitor to the second capacitor in a first direction along a first charge transfer path to add the charge on the first capacitor to the first image sensor charge, thereby obtaining a first accumulated charge;
transferring (t3) the first accumulated charge from the second capacitor to a third capacitor (157) in the first direction along a second charge transfer path to store the first accumulated charge;
acquiring a second image sensor charge, the second image sensor charge being a time delayed version of the first image sensor charge;
transferring the second image sensor charge to a fourth capacitor (160);
transferring the first accumulated charge from the third capacitor to the fourth capacitor in the first direction along a third charge transfer path to add the first accumulated charge to the second image sensor charge, thereby obtaining a second accumulated charge;
transferring the second accumulated charge from the fourth capacitor to a fifth capacitor (161) in the first direction along a fourth charge transfer path to store the second accumulated charge;
storing a charge on the fifth capacitor (161);
acquiring a third image sensor charge;
transferring the third image sensor charge to the fourth capacitor (160);
transferring the charge on the fifth capacitor from the fifth capacitor to the fourth capacitor in a second direction along the fourth charge transfer path to add the charge on the fifth capacitor to the third image sensor charge, thereby obtaining a third accumulated charge;
transferring the third accumulated charge (C(1+2) from the fourth capacitor to a third capacitor (157) in the second direction along the third charge transfer path to store the third accumulated charge;
acquiring a fourth image sensor charge (C(3)), the fourth image sensor charge being a time delayed version of the third image sensor charge;
transferring (t(1)) the fourth image sensor charge to the second capacitor (156);
transferring (t(2)) the third accumulated charge from the third capacitor to the second capacitor in the second direction along the second charge transfer path to add the third accumulated charge to the fourth image sensor charge, thereby obtaining a fourth accumulated charge (C1+2+3)); and
transferring (t(3)) the fourth accumulated charge from the second capacitor to the first capacitor (155) in the second direction along the first charge transfer path to store the fourth accumulated charge; wherein
said first, second, third and fourth charge transfer paths have first gates and second gates respectively connected in series between first and second ends of said first, second, third and fourth charge transfer paths, said first and second gates respectively functioning alternatively as screen gates or as transfer gates according to a clocking phase, thus allowing charge transfer in said first direction or said second direction.

8. A method as in claim 7 wherein:
the step of acquiring first image sensor charge comprises acquiring a first charge from an imaging array at a first time; and
the step of acquiring second image sensor charge comprises acquiring a second charge from the imaging array at a second time delayed from the first time.

9. A method as in claim 7 or 8 wherein:
the step of acquiring third image sensor charge comprises acquiring a third charge from the imaging array at a third time different than the first and second times; and
the step of acquiring fourth image sensor charge comprises acquiring a fourth charge from the imaging array at a fourth time delayed from the third time and different than the first and second times.

## Patentansprüche

1. Zeitverzögerungs-Integrationsschaltung (110) mit:
einer Vielzahl von seriell verbundenen Schaltungsgruppen, deren jede zumindest aufweist:
ein erstes Ladungsübertragungspfadsegment mit einem ersten Gate (113, 121, 129, 137) und einem zweiten Gate (114, 122, 130, 138), die zwischen einem ersten Ende und einem zweiten Ende liegen;
ein zweites Ladungsübertragungspfadsegment mit einem ersten Gate (115, 123, 131, 139) und einem zweiten Gate (116, 124, 132, 140) in Reihe zwischen einem ersten Ende und einem zweiten Ende davon, wobei das erste Ende des zweiten Ladungsübertragungspfads mit dem zweiten Ende des ersten Ladungsübertragungspfads verbunden ist;
einen ersten Kondensator (151, 155, 159, 163), der einen ersten Anschluss verbunden mit dem ersten Ende des ersten Ladungsübertragungspfadsegments und einen zweiten Anschluss aufweist; und
einen zweiten Kondensator (152, 156, 160, 164), der einen ersten Anschluss verbunden mit dem ersten Ende des zweiten Ladungsübertragungspfadsegments und einen zweiten Anschluss aufweist;
einer Vielzahl von Abbildungssensor-Einheitszelleneingängen (101, 103, 105, 107), die jeweils steuerbar mit den ersten Anschlüssen der zweiten Kondensatoren verbunden sind;
einem Schirmspannungsknoten (∅_{B}), der in einer ersten Ladungsübertragungsrichtung mit den ersten Gates und in einer zweiten Ladungsübertragungsrichtung mit den zweiten Gates steuerbar verbunden ist;
einem ersten Phasentaktknoten (∅₁, ∅_{C1}), der mit den zweiten Anschlüssen der ersten Kondensatoren verbunden ist, und steuerbar in der ersten Ladungsübertragungsrichtung mit den zweiten Gates der zweiten Ladungsübertragungspfadsegmente und in der zweiten Ladungsübertragungsrichtung mit den ersten Gates der ersten Ladungsübertragungspfadsegmente verbunden ist; und
einem zweiten Phasentaktknoten (∅₂, ∅_{C2}), der mit den zweiten Anschlüssen der zweiten Kondensatoren verbunden ist, und steuerbar in der ersten Ladungsübertragungsrichtung mit den zweiten Gates der ersten Ladungsübertragungspfadsegmente und in der zweiten Ladungsübertragungsrichtung mit den ersten Gates der zweiten Ladungsübertragungspfadsegmente verbunden ist.

2. Zeitverzögerungs-Integrationsschaltung nach Anspruch 1, ferner mit einer Vielzahl von Rückstelleingängen (102, 104, 106, 108), die jeweils steuerbar mit den ersten Anschlüssen der zweiten Kondensatoren verbunden sind.

3. Zeitverzögerungs-Integrationsschaltung nach Anspruch 1 oder 2, ferner mit einer Vielzahl von Schalter-Schaltungen (170, 171, 172, 173), die Polanschlüsse, die jeweils mit den zweiten Kondensatoren verbunden sind, erste geschaltete Anschlüsse, die jeweils mit den Abbildungssensoreinheitszelleneingängen verbunden sind, und zweite geschaltete Anschlüsse aufweist, die jeweils mit den Rücksetzeingängen verbunden sind.

4. Zeitverzögerungs-Integrationsschaltung nach Anspruch 3, wobei die Schalter-Schaltungen MOSFET-Transistor-Schalter-Schaltungen sind.

5. Zeitverzögerungs-Integrationsschaltung nach Anspruch 1, 2, 3 oder 4, wobei jede der seriell verbundenen Schaltungsgruppen ferner aufweist:
ein drittes Ladungsübertragungspfadsegment mit einem ersten Gate (117, 125, 133, 141) und einem zweiten Gate (118, 126, 134, 142), die in Reihe zwischen einem ersten Ende und einem zweiten Ende davon liegen;
ein viertes Ladungsübertragungspfadsegment mit einem ersten Gate (119, 127, 135, 111) und einem zweiten Gate (120, 128, 136, 112) in Reihe zwischen einem ersten Ende und einem zweiten Ende davon, wobei das erste Ende des zweiten Ladungsübertragungspfads mit dem zweiten Ende des ersten Ladungsübertragungspfads verbunden ist;
einen dritten Kondensator (153, 157, 161, 165), der einen ersten Anschluss verbunden mit dem ersten Ende des dritten Ladungsübertragungspfadsegments und einen zweiten Anschluss aufweist;
einen vierten Kondensator (154, 158, 162, 166), der einen ersten Anschluss verbunden mit dem ersten Ende des vierten Ladungsübertragungspfadsegments und einen zweiten Anschluss aufweist;
wobei der Schirmspannungsknoten (∅_{B}) ferner steuerbar in der ersten Ladungsübertragungsrichtung mit den ersten Gates der dritten und vierten Ladungsübertragungspfade und in einer zweiten Ladungsübertragungsrichtung mit den zweiten Gates der dritten und vierten Ladungsübertragungspfade verbunden ist;
wobei der erste Phasentaktknoten (∅₁, ∅_{C1}) ferner mit den zweiten Anschlüssen der dritten Kondensatoren verbunden ist, und steuerbar in der ersten Ladungsübertragungsrichtung mit den zweiten Gates der vierten Ladungsübertragungspfadsegmente und in der zweiten Ladungsübertragungsrichtung mit den ersten Gates der dritten Ladungsübertragungspfadsegmente steuerbar verbunden ist; und
wobei der zweite Phasentaktknoten (∅₂, ∅_{C2}) ferner mit den zweiten Anschlüssen der vierten Kondensatoren verbunden ist und steuerbar in der ersten Ladungsübertragungsrichtung mit den zweiten Gates der dritten Ladungsübertragungspfadsegmente und in der zweiten Ladungsübertragungsrichtung mit den ersten Gates der vierten Ladungsübertragungspfadsegmente verbunden ist.

6. Zeitverzögerungs-Integrationsschaltung nach Anspruch 1, 2, 3, 4 oder 5, ferner mit einer Vielzahl seriell verbundener MOSFET-Transistoren (111, 112, 113, 114, 115, 116, 117, 118, 119, 120, 121, 122, 123, 124, 125, 126, 127, 128, 129, 130, 131, 132, 133, 134, 135, 136, 137, 138, 139, 140, 141, 142), wobei die ersten und zweiten Gates Gates der MOSFET-Transistoren sind.

7. Verfahren zur Zeitverzögerungs-Integration von Abbildungssensorladungen, mit:
Speichern einer Ladung (E(1)) auf einem ersten Kondensator (155);
Erfassen einer ersten Abbildungssensorladung (E(2));
Übertragen (t1) der ersten Abbildungssensorladung zu einem zweiten Kondensator (156);
Übertragen (t2) der Ladung auf dem ersten Kondensator von dem ersten Kondensator zu dem zweiten Kondensator in einer ersten Richtung entlang eines ersten Ladungsübertragungspfads, um die Ladung dem ersten Kondensator mit der ersten Abbildungssensorladung hinzuzufügen, um damit eine erste akkumulierte Ladung zu erhalten;
Übertragen (t3) der ersten akkumulierten Ladung von dem zweiten Kondensator zu einem dritten Kondensator (157) in der ersten Richtung entlang eines zweiten Ladungsübertragungspfads, um die erste akkumulierte Ladung zu speichern;
Erfassen einer zweiten Abbildungssensorladung, wobei die zweite Abbildungssensorladung eine zeitverzögerte Version der ersten Abbildungssensorladung ist;
Übertragen der zweiten Abbildungssensorladung zu einem vierten Kondensator (160);
Übertragen der ersten akkumulierten Ladung von dem dritten Kondensator zu dem vierten Kondensator in der ersten Richtung entlang des dritten Ladungsübertragungspfads, um der zweiten Abbildungssensorladung die erste akkumulierte Ladung hinzuzufügen, um damit eine zweite akkumulierte Ladung zu erhalten;
Übertragen der zweiten akkumulierten Ladung von dem vierten Kondensator zu einem fünften Kondensator (161) in der ersten Richtung entlang eines vierten Ladungsübertragungspfads, um die zweite akkumulierte Ladung zu speichern;
Speichern einer Ladung auf dem fünften Kondensator (161);
Erfassen einer dritten Abbildungssensorladung;
Übertragen der dritten Abbildungssensorladung zu dem vierten Kondensator (160);
Übertragen der Ladung auf dem fünften Kondensator von dem fünften Kondensator zu dem vierten Kondensator in einer zweiten Richtung entlang des vierten Ladungsübertragungspfads, um der dritten Abbildungssensorladung die Ladung auf dem fünften Kondensator hinzuzufügen, um damit eine dritte akkumulierte Ladung zu erhalten;
Übertragen der dritten akkumulierten Ladung (C(1+2)) von dem vierten Kondensator zu einem dritten Kondensator (157) in der zweiten Richtung entlang des dritten Ladungsübertragungspfads, um die dritte akkumulierte Ladung zu speichern;
Erfassen einer vierten Abbildungssensorladung (C(3)), wobei die vierte Abbildungssensorladung eine zeitverzögerte Version der dritten Abbildungssensorladung ist;
Übertragen (t(1)) der vierten Abbildungssensorladung zu dem zweiten Kondensator (156);
Übertragen (t(2)) der dritten akkumulierten Ladung von dem dritten Kondensator zu dem zweiten Kondensator in der zweiten Richtung entlang des zweiten Ladungsübertragungspfads, um die dritte akkumulierte Ladung der vierten Abbildungssensorladung hinzuzufügen, um damit eine vierte akkumulierte Ladung (C1+2+3)) zu erhalten; und
Übertragen (t(3)) der vierten akkumulierten Ladung von dem zweiten Kondensator zu dem ersten Kondensator (155) in der zweiten Richtung entlang des ersten Ladungsübertragungspfads, um die vierte akkumulierte Ladung zu speichern, wobei
der erste, der zweite, der dritte und der vierte Ladungsübertragungspfad erste Gates und zweite Gates aufweisen, die jeweils in Reihe zwischen einem ersten und einem zweiten Ende des ersten, des zweiten, des dritten und des vierten Ladungsübertragungspfads angeschlossen sind, wobei das erste und das zweite Gate jeweils alternativ als Schirmgates oder als Übertragungsgates entsprechend einer Taktphase funktionieren, um damit eine Ladungsübertragung in die erste Richtung oder die zweite Richtung zu erlauben.

8. Verfahren nach Anspruch 7, wobei:
der Schritt des Erfassens der ersten Abbildungssensorladung das Erfassen einer ersten Ladung von einer Abbildungsgruppe zu einem ersten Zeitpunkt umfasst; und
der Schritt des Erfassens der zweiten Abbildungssensorladung ein Erfassen einer zweiten Ladung von der Abbildungsgruppe zu einem zweiten Zeitpunkt verzögert zu dem ersten Zeitpunkt umfasst.

9. Verfahren nach Anspruch 7 oder 8, wobei:
der Schritt des Erfassens der dritten Abbildungssensorladung das Erfassen einer dritten Ladung von der Abbildungsgruppe zu einem dritten Zeitpunkt umfasst, der sich von dem ersten und dem zweiten Zeitpunkt unterscheidet; und
der Schritt des Erfassens der vierten Abbildungssensorladung das Erfassen einer vierten Ladung von der Abbildungsgruppe zu einem vierten Zeitpunkt umfasst, der gegenüber dem dritten Zeitpunkt verzögert ist und sich von dem ersten und dem zweiten Zeitpunkt unterscheidet.

## Revendications

1. Circuit (110) d'intégration à retard temporel comportant :
une pluralité de groupes de circuits reliés en série, chacun comportant au moins :
un premier segment de chemin de transfert de charge ayant une première porte (113, 121, 129, 137) ainsi qu'une deuxième porte (114, 122, 130, 138) en série entre une première extrémité et une deuxième extrémité de celui-ci ;
un deuxième segment de chemin de transfert de charge ayant une première porte (115, 123, 131, 139) ainsi qu'une deuxième porte (116, 124, 132, 140) en série entre une première extrémité et une deuxième extrémité de celui-ci, la première extrémité du deuxième chemin de transfert de charge étant reliée à la deuxième extrémité du premier chemin de transfert de charge ;
un premier condensateur. (151, 155, 159, 163) ayant une première borne reliée à la première extrémité du premier segment de chemin de transfert de charge ainsi qu'une deuxième borne ; et
un deuxième condensateur (152, 156, 160, 164) ayant une première borne reliée à la première extrémité du deuxième segment de chemin de transfert de charge ainsi qu'une deuxième borne ;
une pluralité d'entrées (101, 103, 105, 107) de cellule de module de capteur d'imagerie respectivement reliées de façon à pouvoir être commandées aux premières bornes des deuxièmes condensateurs ;
un noeud (∅_{B}) de tension d'écran relié de façon à pouvoir être commandé dans une première direction de transfert de charge aux premières portes et dans une deuxième direction de transfert de charge aux deuxièmes portes ;
un premier noeud (∅₁, ∅_{C1}) d'horloge de phase relié aux deuxièmes bornes des premiers condensateurs et relié de façon à pouvoir être commandé dans la première direction de transfert de charge aux deuxièmes portes des deuxièmes segments de chemin de transfert de charge et dans la deuxième direction de transfert de charge aux premières portes des premiers segments de chemin de transfert de charge ; et
un deuxième noeud (∅₂, ∅_{C2}) d'horloge de phase relié aux deuxièmes bornes des deuxièmes condensateurs et relié de façon à pouvoir être commandé dans la première direction de transfert de charge aux deuxièmes portes des premiers segments de chemin de transfert de charge et dans la deuxième direction de transfert de charge aux premières portes des deuxièmes segments de chemin de transfert de charge.

2. Circuit d'intégration à retard temporel selon la revendication 1, comportant de plus une pluralité d'entrées (102, 104, 106, 108) de remise à l'état initial respectivement reliées de façon à pouvoir être commandées aux premières bornes des deuxièmes condensateurs.

3. Circuit d'intégration à retard temporel selon la revendication 1 ou 2, comportant de plus une pluralité de circuits (170, 171, 172, 173) de commutation ayant des bornes de pôle reliées respectivement aux deuxièmes condensateurs, des premières bornes commutées reliées respectivement aux entrées de cellule du module de capteur d'imagerie et des deuxièmes bornes commutées reliées respectivement aux entrées de remise à l'état initial.

4. Circuit d'intégration à retard temporel selon la revendication 3, dans lequel les circuits de commutation sont des circuits de commutation à transistor MOSFET.

5. Circuit d'intégration à retard temporel selon la revendication 1, 2, 3 ou 4, dans lequel chacun des groupes de circuits reliés en série comporte de plus :
un troisième segment de chemin de transfert de charge ayant une première porte (117, 125, 133, 141) ainsi qu'une deuxième porte (118, 126, 134, 142) en série entre une première extrémité et une deuxième extrémité de celui-ci ;
un quatrième segment de chemin de transfert de charge ayant une première porte (119, 127, 135, 111) ainsi qu'une deuxième porte (120, 128, 136, 112) en série entre une première extrémité et une deuxième extrémité de celui-ci, la première extrémité du deuxième chemin de transfert de charge étant reliée à la deuxième extrémité du premier chemin de transfert de charge ;
un troisième condensateur (153, 157, 161, 165) ayant une première borne reliée à la première extrémité du troisième segment de chemin de transfert de charge ainsi qu'une deuxième borne ; et
un quatrième condensateur (154, 158, 162, 166) ayant une première borne reliée à la première extrémité du quatrième segment de chemin de transfert de charge ainsi qu'une deuxième borne ;
dans lequel le noeud (∅_{B}) de tension d'écran est de plus relié de façon à pouvoir être commandé dans la première direction de transfert de charge aux premières portes des troisième et quatrième chemins de transfert de charge et dans une deuxième direction de transfert de charge aux deuxièmes portes des troisième et quatrième chemins de transfert de charge ;
dans lequel le premier noeud (∅₁, ∅_{C1}) d'horloge de phase est de plus relié aux deuxièmes bornes des troisièmes condensateurs et relié de façon à pouvoir être commandé dans la première direction de transfert de charge aux deuxièmes portes des quatrièmes segments de chemins de transfert de charge et dans la deuxième direction de transfert de charge aux premières portes des troisièmes segments de chemin de transfert de charge ; et
dans lequel le deuxième noeud (∅₂, ∅_{C2}) d'horloge de phase est de plus relié aux deuxièmes bornes des quatrièmes condensateurs et relié de façon à pouvoir être commandé dans la première direction de transfert de charge aux deuxièmes portes des troisièmes segments de chemin de transfert de charge et dans la deuxième direction de transfert de charge aux premières portes des quatrièmes segments de chemin de transfert de charge.

6. Circuit d'intégration à retard temporel selon la revendication 1, 2, 3, 4 ou 5, comportant de plus une pluralité de transistors (111, 112, 113, 114, 115, 116, 117, 118, 119, 120, 121, 122, 123, 124, 125, 126, 127, 128, 129, 130, 131, 132, 133, 134, 135, 136, 137, 138, 139, 140, 141, 142) MOSFET reliés en série, les premières et deuxièmes portes étant des portes des transistors MOSFET.

7. Procédé d'intégration à retard temporel de charges de capteur d'image, comportant :
un stockage d'une charge (E(1)) dans un premier condensateur (155) ;
une acquisition d'une première charge (E(2)) de capteur d'image ;
un transfert (t1) de la première charge de capteur d'image à un deuxième condensateur (156) ;
un transfert (t2) de la charge du premier condensateur à partir du premier condensateur vers le deuxième condensateur dans une première direction le long d'un premier chemin de transfert de charge afin d'ajouter la charge du premier condensateur à la première charge de capteur d'image, obtenant ainsi une première charge accumulée ;
un transfert (t3) de la première charge accumulée à partir du deuxième condensateur vers un troisième condensateur (157) dans la première direction le long d'un deuxième chemin de transfert de charge afin de stocker la première charge accumulée ;
une acquisition d'une deuxième charge de capteur d'image, la deuxième charge de capteur d'image étant une version retardée dans le temps de la première charge de capteur d'image ;
un transfert de la deuxième charge de capteur d'image à un quatrième condensateur (160) ;
un transfert de la première charge accumulée à partir du troisième condensateur vers le quatrième condensateur dans la première direction le long d'un troisième chemin de transfert de charge afin d'ajouter la première charge accumulée à la deuxième charge de capteur d'image, obtenant ainsi une deuxième charge accumulée ;
un transfert de la deuxième charge accumulée à partir du quatrième condensateur vers un cinquième condensateur (161) dans la première direction le long d'un quatrième chemin de transfert de charge afin de stocker la deuxième charge accumulée ;
un stockage d'une charge du cinquième condensateur (161) ;
une acquisition d'une troisième charge de capteur d'image ;
un transfert de la troisième charge de capteur d'image à un quatrième condensateur (160) ;
un transfert de la charge du cinquième condensateur à partir du cinquième condensateur vers le quatrième condensateur dans une deuxième direction le long du quatrième chemin de transfert de charge afin d'ajouter la charge du cinquième condensateur à la troisième charge du capteur d'image, obtenant ainsi une troisième charge accumulée ;
un transfert de la troisième charge (C(1+2)) accumulée à partir du quatrième condensateur vers un troisième condensateur (157) dans la deuxième direction le long du troisième chemin de transfert de charge afin de stocker la troisième charge accumulée ;
une acquisition d'une quatrième charge (C(3)) de capteur d'image, la quatrième charge de capteur d'image étant une version retardée dans le temps de la troisième charge de capteur d'image ;
un transfert (t(1)) de la quatrième charge de capteur d'image vers le deuxième condensateur (156) ;
un transfert (t(2)) de la troisième charge accumulée à partir du troisième condensateur vers le deuxième condensateur dans la deuxième direction le long du deuxième chemin de transfert de charge afin d'ajouter la troisième charge accumulée à la quatrième charge de capteur d'image, obtenant ainsi une quatrième charge (C(1+2+3)) accumulée ; et
un transfert (t(3)) de la quatrième charge accumulée à partir du deuxième condensateur vers le premier condensateur (155) dans la deuxième direction le long du premier chemin de transfert de charge afin de stocker la quatrième charge accumulée ; où
lesdits premier, deuxième, troisième et quatrième chemins de transfert de charge ont des premières portes et des deuxièmes portes reliées respectivement en série entre les premières et deuxièmes extrémités desdits premier, deuxième, troisième et quatrième chemins de transfert de charge, lesdites premières et deuxièmes portes fonctionnant respectivement de façon alternative comme des portes écran ou comme des portes de transfert conformément à une phase d'horloge, permettant ainsi un transfert de charge dans ladite première direction ou ladite deuxième direction.

8. Procédé selon la revendication 7, dans lequel :
l'étape d'acquisition d'une première charge de capteur d'image comporte une acquisition d'une première charge à partir d'une matrice d'imagerie à un premier instant ; et
l'étape d'acquisition d'une deuxième charge de capteur d'image comporte une acquisition d'une deuxième charge à partir de la matrice d'imagerie à un deuxième instant retardé par rapport au premier instant.

9. Procédé selon la revendication 7 ou 8, dans lequel :
l'étape d'acquisition d'une troisième charge de capteur d'image comporte une acquisition d'une troisième charge à partir de la matrice d'imagerie à un troisième instant différent des premier et deuxième instants ; et
l'étape d'acquisition d'une quatrième charge de capteur d'image comporte une acquisition d'une quatrième charge à partir de la matrice d'imagerie à un quatrième instant retardé par rapport au troisième instant et différent des premier et deuxième instants.
